(19) Europäisches Patentamt
European Patent Office
Office européen des brevets

(11) Publication number: 0 343 603 B1

(12) **EUROPEAN PATENT SPECIFICATION**

(45) Date of publication of patent specification: **17.08.94** (51) Int. Cl.5: **G03F 7/039**

(21) Application number: **89109284.3**

(22) Date of filing: **23.05.89**

# (54) High-sensitivity, high-resolution positive-type electron-beam resist.

(30) Priority: **24.05.88 JP 126164/88**
**24.10.88 JP 267507/88**
**03.04.89 JP 85569/89**
**06.04.89 JP 87703/89**

(43) Date of publication of application:
**29.11.89 Bulletin 89/48**

(45) Publication of the grant of the patent:
**17.08.94 Bulletin 94/33**

(84) Designated Contracting States:
**DE NL**

(56) References cited:
**EP-A- 0 007 976**

**JOURNAL OF THE ELECTROCHEMICAL SOCIETY, vol. 128, no. 5, May 1981, MANCHESTER, NEW HAMP, pp. 1065-1071 ; H. HIRAOKA : "All Dry Lithography Processes and Mechanistic Studies with Poly(methacrylonitrile) and related Polymers"**

(73) Proprietor: **Toppan Printing Co., Ltd.**
**5-1, 1-chome, Taito**
**Taito-ku Tokyo (JP)**

(72) Inventor: **Tamura, Akira**
**3-1-3, Tomisato**
**Kashiwa-shi Chiba-ken (JP)**
Inventor: **Tanaka, Keishi**
**2-1-9, Seiji**
**Sugito-machi**
**Kitakatsushika-gun Saitama-ken (JP)**
Inventor: **Sugiura, Takeo**
**2130-128, Koyo-cho**
**Tokorozawa-shi Saitama-ken (JP)**

(74) Representative: **Bühling, Gerhard, Dipl.-Chem. et al**
**Patentanwaltsbüro**
**Tiedtke-Bühling-Kinne & Partner**
**Bavariaring 4**
**D-80336 München (DE)**

**EP 0 343 603 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**IBM TECHNICAL DISCLOSURE BULLETIN, vol. 16, no. 11, April 1974, NEW YORK US, p. 3745, O.U. NEED : "Polymethyl Alpha Cyanoacrylate Homopolymers and Copolymers As High-Speed Positive Electron-Beam Resists"**

**IBM TECHNICAL DISCLOSURE BULLETIN, vol. 17, no. 5, October 1974, NEW YORK US, p. 1354, E.C. Fredericks et al.: "Positive Resists With Increased Adhesion"**

## Description

The present invention relates to a high-sensitivity, high-resolution positive-type electron-beam resist and a method of forming a pattern using the same and, more particularly, to formation of a resist pattern for the manufacture of a photomask in the semiconductor industry and for selective etching or selective diffusion in the manufacture of a semiconductor performed by direct drawing on a silicon wafer.

A negative-type resist is high in sensitivity but low in resolution. On the contrary, a positive-type resist is high in resolution but low in sensitivity. Therefore, as a packing density of LSICs (Large Scaled Integrated Circuits) has increased, a positive-type resist has been increasingly used as compared with a negative-type resist. A known typical example of the positive-type electron-beam resist is poly(methyl methacrylate) (PMMA). The sensitivity of PMMA, however, is as low as about 100 $\mu C/cm^2$ at an accelerating voltage of 20 kV. For this reason, throughput of an electron-beam exposure apparatus becomes problematic, and therefore many studies have been made in order to increase the sensitivity. Proposed examples are poly-(butene-1-sulfone), poly(trifluoroethyl-2-chloromethacrylate), poly(hexafluorobutylmethacrylate), poly-(isopropenylketone), and a copolymer of methyl methacrylate and methacrylic acid. Sensitivity of some of these electron-beam resists is higher than that of PMMA. The sensitivity, however, should desirably be higher than 4 $\mu C/cm^2$ (accelerating voltage = 20 kV) when the throughput of in electron-beam drawing apparatus is taken into consideration. In addition, various conditions such as high resolution, a high heat resistance, an adhesion property with respect to a substrate, process stability, and storage stability (pot life) are required. For this purposes a development step after pattern exposure of an electron beam and the physical properties of an electron-beam resist itself must be improved. These problems are still left unsolved.

In EP-A-0 007 976 a process for forming pattern on a positive-type electron-beam resist mainly consisting of a copolymer comprising $\alpha$ substituted acrylonitrile and cyclohexyl-2-cyanoacrylateas comonomers is disclosed.

It is an object of the present invention to provide a positive-type electron-beam resist having both high sensitivity and high resolution for an LSIC of a 16-megabit DRAM or more.

It is another object of the present invention to provide a method of forming a micro pattern of a sub-micron order by setting suitable development conditions of the above positive-type electron-beam resist.

That is, the positive-type electron-beam resist of the present invention mainly consists of a monopolymer of cyclohexyl-2-cyanoacrylate, or a copolymer of alkyl-2-cyanoacrylate and cyclohexyl-2-cyanoacrylate represented by following formula (I):

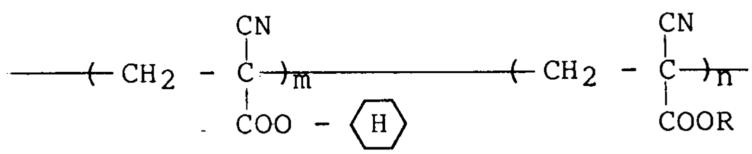

...(I)

wherein R represents a methyl or ethyl group and a molar ratio n/m = 0 to 0.4 and having a weight-average molecular weight ($\overline{M}w$) of 100,000 to 1,500,000 characterized in that 5 to 20 wt% of quaternary ammonium perchlorate represented by formula (II) based on the amount of the polymer of the general formula (I) are added to said polymer represented by formula (I)

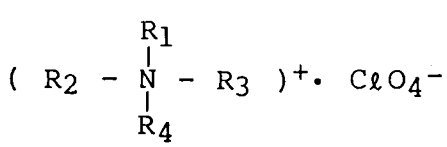

... (II)

wherein each of $R_1$, $R_2$, $R_3$, and $R_4$ represents an alkyl group having 1 to 20 carbon atoms.

When the ratio n/m is 0, i.e., when n = 0, formula (I) is represented by following formula (Ia):

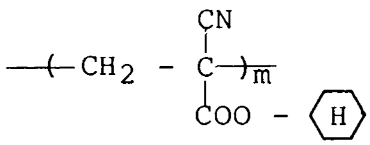

...(Ia)

A pattern formation method using the positive-type electron-beam resist of the present invention is characterized by using a solvent mixture of an organic solvent as a solvent of the resist and an organic solvent as a non-solvent of the resist as a developing solution in a development step in which an electron beam is selectively radiated to the positive-type electron-beam resist mainly consisting of formula (I) or (Ia) and (II), and a portion of the resist which is disintegrated into a compound of low molecular weight is selectively dissolved by a solvent, thereby obtaining a positive-type resist pattern.

A positive-type electron-beam resist mainly consisting of a monopolymer or copolymer of cyclohexyl-2-cyanoacrylate represented by formula (I) and of 5 to 20 wt% of a quaternary ammonium perchlorate represented by formula (II) will be described below.

The positive-type electron-beam resist mainly consisting of a cyclohexyl 2-cyanoacrylate polymer represented by:

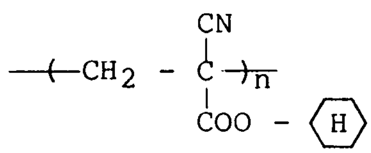

is prepared by anion-polymerizing or radical-polymerizing a cyclohexyl 2-cyanoacrylate monomer obtained by a conventional synthesizing method. A weight-average molecular weight of the positive-type electron-beam resist is 100,000 to 1,500,000 in terms of a coating property and sensitivity. In consideration of resolution of a micro pattern, a molecular weight distribution of the polymer preferably falls within a narrow range. This is a problem of a degree of dispersion of the molecular weight of the polymer. The degree of dispersion is defined by:

$$\frac{\text{weight-average molecular weight } (\bar{M}w)}{\text{number-average molecular weight } (Mn)}$$

When the value of the degree of dispersion is ideally one, this polymer is called a mono disperse polymer because molecular weights are uniform.

In the present invention, the degree of dispersion of the polymer is preferably three or less in terms of high resolution and high contrast of a pattern. More preferably, the polymer is a mono disperse polymer having a degree of dispersion of practically two or less, and ideally, close to one.

The polymer close to a mono disperse polymer is prepared by polymerizing a cyclohexyl 2-cyanoacrylate monomer singly or with a copolymerizable 2-cyanoacrylate by a low-temperature anion polymerization method. More specifically, a monomer to be monopolymerized or copolymerized is polymerized, while it is cooled to 20 to -120 °C, in the presence of an anion polymerization initiator consisting of one or more weak anions such as an organic amine, an organic amide, a phosphine, a thiourea, a thiol alcohol, and an ether. Polymerization examples will be described below.

[Polymerization Example 1] ... Monopolymer

700 mℓ of a polymerization solvent of acetone containing $5 \times 10^{-5}$ mol of n-butylamine as a polymerization initiator were supplied in a flask, and the flask was cooled to -80 °C.

While the solution was sufficiently stirred, 100 mℓ of an acetone solution containing 0.1 mol of cyclohexyl 2-cyanoacrylate were sequentially added and polymerized while keeping the temperature of the solution not to exceed -80 °C. An acid was then added to the resultant material to stop the reaction. The resultant material was purified by a reprecipitation method, and its molecular weight was measured by a gel

permeation chromatography (GPC) - light scattering method. As a result, a weight-average molecular weight ($\overline{M}w$) was 385,000, and a degree of dispersion was 1.05 which was a value close to that of mono dispersion. Note that a polymerization ratio (yield) was 97.3%.

[Polymerization Example 2] ... Copolymer

700 mℓ of an acetone polymerization solvent containing $5 \times 10^{-5}$ mol of aniline as a polymerization initiator were supplied in a flask, and the flask was cooled to -70 °C.

While the solution was sufficiently stirred, 100 mℓ of an acetone solution containing cyclohexyl 2-cyanoacrylate/ethyl 2-cyanoacrylate = 0.07 mol/0.03 mol were sequentially added and polymerized while keeping the temperature of the resultant solution not to exceed -70 °C. Following the same procedures as in Polymerization Example 1, a copolymer close to mono dispersion, having a molecular weight ($\overline{M}w$) of 250,000, a degree of dispersion of 1.06, and a polymerization ratio of 96.8%, was prepared.

Although the anion polymerization method has been described above, polymerization may be performed in accordance with a radical polymerization degree. In the radical polymerization method, a molecular weight distribution of a prepared polymer tends to be widened. In this case, only a polymer having a molecular weight of a predetermined range can be extracted by classification.

A monopolymer or copolymer prepared by substituting an ester group of cyanoacrylate with a cyclohexyl group has high storage stability and a high heat resistance. These properties advantageously allow an electron-beam resist to become suitable for long-term storage and to have durability against a heat treatment such as burning.

The following table shows comparison of properties between monopolymers in which a cyclohexyl group is substituted by a methy group or a propyl group.

| Substituent Group | Storage Stability | Solvent Resistance | Overall Evaluation |
|---|---|---|---|
| $-CH_3$ | Poor | Good | × |
| $-C_2H_5$ | Rather Poor | Good | Δ |
| $-C_4H_9$ | Good | Poor | X |
| 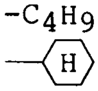 (Present Invention) | Good | Good | o |

According to the present invention, the sensitivity and resolution of the positive-type electron-beam resist are further improved by adding a strong electrolytic substance, the substance being quaternary ammonium perchlorate represented by formula (II):

$$\left( R_2 - \underset{\underset{R_4}{|}}{\overset{\overset{R_1}{|}}{N}} - R_3 \right)^{+} \cdot ClO_4^{-} \qquad \text{... (II)}$$

(wherein each of $R_1$, $R_2$, $R_3$, and $R_4$ independently represents an alkyl group having 1 to 20 carbon atoms).

Quaternary ammonium perchlorate is added within the range of 5 to 20 wt% in consideration of the sensitivity and resolution, based on the amount of the cyclohexyl 2-cyanoacrylate polymer.

[Pattern Formation Method]

A developing solution for use in the present invention will be described below. Examples of an organic solvent of the cyclohexyl 2-cyanoacrylate polymer are acetone, methyl ethyl ketone, methyl isobutyl ketone, methyl isoamyl ketone, cyclohexanone, methyl acetate, ethyl acetate, propyl acetate, butyl acetate, amyl

acetate, methyl cellosolve(2-methoxyethanol), methyl cellosolve acetate, ethyl cellosolve acetate, propyl cellosolve acetate, butyl cellosolve acetate, dimethyl cellosolve, diethyl cellosolve, methyl carbitol, ethyl carbitol, methyl carbitol acetate, ethyl carbitol acetate, N,N-demethylformamide, N,N-dimethylacetamide, dimethyl sulfoxide, diethyl ether, tetrahydrofuran, toluene, xylene, benzene, chloroform, and dichloromethane. A non-solvent of the polymer is mixed to suppress dissolution of an electron-beam non-radiated portion. If, however, a mixing ratio of the non-solvent is too large, the sensitivity is lowered. Examples of the non-solvent are methanol, ethanol, 2-propanol, butanol, ethyl cellosolve, butyl cellosolve, propyl cellosolve, hexane, cyclohexane, and naphtha.

Although a mixing ratio of the organic solvents as a solvent and a non-solvent of the polymer depends on the type of used solvents, a volume ratio of the organic non-solvent generally falls within the range of 0.2 to 4 with respect to one volume of the organic solvent. Mixing of the organic non-solvent reduces dissolving power of a developing solution with respect to the resist. That is, by using a developing solution having properly adjusted dissolving power, a resist pattern can be developed with high precision.

An example of the proper developing solution is a developing solution containing 2-methoxyethanol-(methyl cellosolve) as an organic solvent, at least one of other solvents, and one or more non-solvents. 2-methoxyethanol is a developing solution which satisfies both the high sensitivity and resolution. If, however, only 2-methoxyethanol is used as the solvent, a formed resist pattern swells and peels because a developing time is too long. Therefore, in order to shorten the developing time, another solvent may be mixed. However, as a mixing ratio of the solvent other than 2-methoxyethanol is increased, the resolution is lowered. Therefore, it is preferred to minimize the mixing ratio of the additional solvent(s). Examples of the solvent other than 2-methoxyethanol are those enumerated above. In addition, one or more types of non-solvent may be selected from those enumerated above.

As another developing solution, a solvent mixture containing 2-methoxyethanol as the solvent and 2-alkoxyethanol represented by formula (III):

$R_5OCH_2CH_2OH$ (III)

(wherein $R_5$ represents an alkyl group having 2 to 4 carbon atoms) as the non-solvent is also effective. With this developing solution, the shape of a developed pattern is improved.

Since the monopolymer or copolymer of cyclohexyl-2-cyanoacrylate contains a cyano group which is a strong electron attraction group, its straight-chain carbon-to-carbon bond is easily ruptured upon radiation of an electron beam. That is, this polymer can be easily converted to one having a low molecular weight and therefore can be considered to have high sensitivity. A low-molecular-weight portion is dissolved and removed by the developing solution consisting of organic solvents, thereby performing patterning.

This positive-type electron-beam resist decomposes even when a radiation amount of the electron beam is small. Actually, the sensitivity of the resist falls within the range of 1 to 4 $\mu C/cm^2$ and is high.

In addition, as compared with a straight-chain alkyl group, a cyclohexyl group improves the storage stability and heat resistance. This results in improvements in a pot life and durability in a wafer process of the positive-type electron-beam resist.

The resolution reaches 0.5 $\mu m$ so that it can be used for manufacturing a 16-megabit DRAM.

Also, in the positive-type electron-beam resist using a copolymer represented by formula (I), the durability with respect to the organic solvents (developing solution) is improved. Therefore, a degree of freedom of selection for the organic solvents for use in the developing solution is increased to widen a range of developing conditions.

By the addition of quaternary ammonium perchlorate represented by formula (II) the sensitivity of this positive-type electron-beam resist is increased about three times. In addition, the resolution is increased by setting a molecular weight distribution of the polymer used in the positive-type electron-beam resist of the present invention in a narrow range, i.e., by decreasing the value of the degree of dispersion.

Moreover, the sensitivity and resolution of the positive-type electron-beam resist can be increased by arbitrarily selecting the developing conditions, especially, the developing solution.

The present invention will be described in more detail below by way of its examples. The present invention, however, is not limited to these examples.

[Example 1]

A 5-wt% cyclohexanone solution of a cyclohexyl 2-cyanoacrylate polymer having a molecular weight of 510,000 was prepared, and 10 wt% of tetra-n-butylammonium perchlorate were added to the polymer. A 4,300-Å thick resist film was formed at 1,500 rpm by a spin coating method on a glass substrate on which

chromium was deposited to a thickness of 1,000 Å. After the resist film was heated at 120 °C for 30 minutes, an electron beam was radiated with a radiation amount of 1 $\mu C/cm^2$ and an acceleration voltage of 10 kV. After electron beam radiation, the resist film was dipped in a solvent mixture of 2-methoxyethanol : 2-propanol = 85 : 15 at 20 °C for one minute, rinsed with 2-propanol, and then dried to obtain a positive resist pattern. Thereafter, the positive resist pattern was heated at 120 °C for 30 minutes and dipped in a chromium etching solution containing cerium ammonium nitrate and perchloric acid for 50 seconds, thereby etching the 1,000-Å chromium layer. When the resist film was removed by acetone, a chromium pattern having a line width of 0.5 µm was formed on the glass substrate.

## Claims

1. A positive-type electron-beam resist mainly consisting of a monopolymer of cyclohexyl-2-cyanoacrylate, or a copolymer of alkyl-2-cyanoacrylate and cyclohexyl-2-cyanoacrylate represented by formula (I):

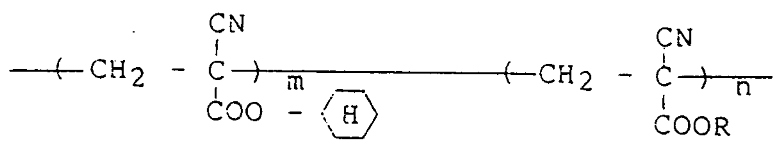

wherein R represents a methyl or ethyl group and a molar ratio n/m = 0 to 0.4 and having a weight-average molecular weight (Mw) falling within a range of 100,000 to 1,500,000,
characterized in that 5 to 20 wt% of quaternary ammonium perchlorate represented by formula (II) based on the amount of the polymer of the general formula (I) are added to said polymer represented by formula (I)

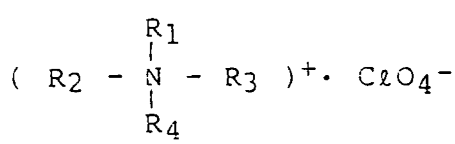

wherein each of $R_1$, $R_2$, $R_3$, and $R_4$ represents an alkyl group having 1 to 20 carbon atoms.

2. A resist according to claim 1, characterized in that a value of a degree of dispersion (weight-average molecular weight ($\overline{Mw}$)/number-average molecular weight ($\overline{Mn}$) of said monopolymer or said copolymer is not more than three.

3. A method of forming a pattern of the positive-type electron-beam resist of claims 1 or 2, which comprises the steps of selectively irradiating an electron beam to decompose a portion of the resist which is irradiated with the electron beam into a compound of a low molecular weight, and dissolving the irradiated portion by using as a developing solution a mixed solvent comprising an organic solvent and a non-solvent of said positive electron-beam resist thereby to obtain a positive-type resist pattern.

4. A method according to claim 3, characterized in that said developing solution is a solvent mixture of three or more components including 2-methoxyethanol as an organic solvent as a solvent of the resist, at least one of other organic solvents as solvents of the resist, and at least one organic solvent as a non-solvent of the resist.

5. A method according to claim 3, characterized in that said developing solution is a solvent mixture containing 2-methoxyethanol as a solvent of the resist and 2-alkoxyethanol represented by formula (III) as a non-solvent of the resist

$R_5OCH_2CH_2OH$ (III)

wherein R5 represents an alkyl group having 2 to 4 carbon atoms.

## Patentansprüche

1. Positivresist für Elektronenstrahlen, der hauptsächlich aus einem Monopolymer von Cyclohexyl-2-cyanoacrylat oder einem Copolymer aus Alkyl-2-cyanoacrylat und Cyclohexyl-2-cyanoacrylat besteht, das durch die Formel (I) dargestellt wird:

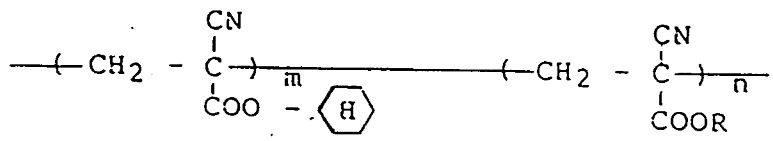

, worin R eine Methyl- oder Ethylgruppe ist und ein molares Verhältnis n/m = 0 bis 0,4 ist, und wobei die Verbindung ein Molekulargewicht im Gewichtsmittel (Mw) hat, das in dem Bereich von 100 000 bis 1 500 000 fällt, dadurch gekennzeichnet, daß 5 bis 20 Gew.-% des quarternären Ammoniumperchlorats, das durch die Formel (II) dargestellt wird, bezogen auf die Menge des Polymers mit der allgemeinen Formel (I), zu dem durch die Formel (I) dargestellten Polymer hinzugefügt werden

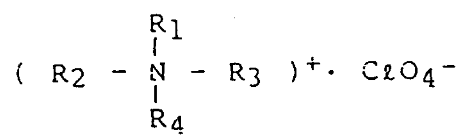

, worin jede der Gruppen $R_1$, $R_2$, $R_3$ und $R_4$ eine Alkylgruppe mit 1 bis 20 Kohlenstoff-Atomen ist.

2. Resist nach Anspruch 1, dadurch gekennzeichnet, daß der Wert des Dispersionsgrads (Molekulargewicht im Gewichtsmittel ($\overline{Mw}$)/Molekulargewicht im Zahlenmittel ($\overline{Mn}$)) des Monopolymers oder des Copolymers nicht mehr als drei ist.

3. Verfahren zur Musterbildung aus dem Positivresist für Elektronenstrahlen nach einem der Ansprüche 1 oder 2, das die folgenden Schritte umfaßt: selektives Bestrahlen mit einem Elektronenstrahl unter Zersetzung des Bereichs des Resists, der mit dem Elektronenstrahl bestrahlt wird, in eine Verbindung mit niedrigem Molekulargewicht, und Lösen des bestrahlten Bereichs, indem als eine Entwicklungslösung ein vermischtes Lösungsmittel verwendet wird, das ein organisches Lösungsmittel und ein den Positivresist für Elektronenstrahlen nicht lösendes Mittel umfaßt, wodurch man ein Positivresist-Muster erhält.

4. Verfahren nach Anspruch 3, dadurch gekennzeichnet, daß die Entwicklungslösung eine Lösungsmittelmischung aus drei oder mehreren Bestandteilen, umfassend 2-Methoxyethanol als ein organisches Lösungsmittel als ein Resist-Lösungsmittel, mindestens ein weiteres organisches Lösungsmittel als Resist-Lösungsmittel und mindestens ein organisches Lösungsmittel als ein den Resist nicht lösendes Mittel, ist.

5. Verfahren nach Anspruch 3, dadurch gekennzeichnet, daß die Entwicklungslösung eine Lösungsmittelmischung ist, die 2-Methoxyethanol als ein Resist-Lösungsmittel und 2-Alkoxyethanol, dargestellt durch Formel (III), als ein den Resist nicht lösendes Mittel enthält,

$R_5OCH_2CH_2OH$

, worin $R_5$ eine Alkylgruppe mit 2 bis 4 Kohlenstoff-Atomen ist.

## Revendications

1. Réserve positive pour rayons électroniques constituée essentiellement d'un monopolymère de cyclohexyle-2-cyanoacrylate, ou d'un copolymère d'alkyle-2-cyanoacrylate et cyclohexyle-2-cyanoacrylate représenté par la formule (I) :

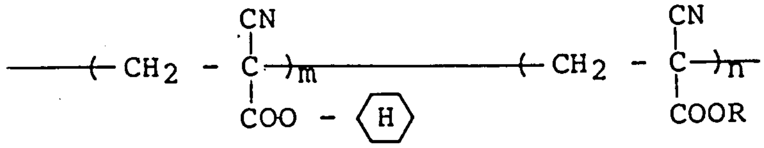

...(I)

où R représente un groupement méthyle ou éthyle et un rapport moléculaire n/m de 0 à 0,4 et ayant une masse moléculaire (Mw) en poids dans la plage allant de 100.000 à 1.00.000, caractérisée en ce qu'on ajoute de 5 à 20 % en poids de perchlorate d'ammonium quaternaire représenté par la formule (II), en fonction de la quantité du polymère dans la formule générale (I), audit polymère représenté par la formule (I)

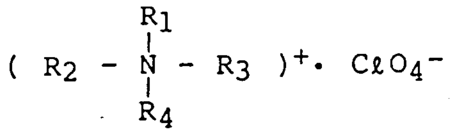

... (II)

où chacun de $R_1$, $R_2$, $R_3$, et $R_4$ représente un groupement alkyle ayant entre 1 et 20 atomes de carbone.

**2.** Réserve selon la revendication 1, caractérisé en ce qu'une valeur d'un degré de dispersion (masse moléculaire en poids ($\overline{M}w$) / masse moléculaire en nombre ($\overline{M}n$)) dudit monopolymère ou dudit copolymère n'excède pas trois.

**3.** Méthode de formation d'un motif de la réserve positive pour rayons électroniques selon la revendication 1 ou la revendication 2, comprenant les étapes consistant à irradier sélectivement un rayon électronique pour décomposer une portion de la réserve qui est irradiée, à l'aide du rayon électronique, en un composé de faible poids moléculaire, et à dissoudre la portion irradiée en utilisant, comme solution de développement, un solvant mixte comprenant un solvant organique et un non-solvant de ladite réserve positive pour rayons électroniques, pour ainsi obtenir un motif de réserve positive.

**4.** Méthode selon la revendication 3, caractérisée en ce que ladite solution de développement est un mélange solvant d'au moins trois constituants dont le 2-méthoxyéthanole en tant que solvant organique en tant que solvant de la réserve au moins un parmi d'autres solvants organiques en tant que solvants de la réserve, et au moins un solvant organique en tant que non-solvant de la réserve.

**5.** Méthode selon la revendication 3, caractérisée en ce que ladite solution de développement est un mélange solvant comportant le 2-méthoxyéthanole en tant que solvant de la réserve et le 2-alkoxyéthanole représenté par la formule (III) en tant que non-solvant de la réserve

$R_5OCH_2CH_2OH$

où $R_5$ représente un groupement alkyle ayant entre 2 et 4 atomes de carbone.